# EUROPEAN PATENT APPLICATION

(11) **EP 4 715 404 A1**
(43) Date of publication of application: **25.03.2026**
(21) Application number: 24852141.1
(22) Date of filing: 25.07.2024
(51) Int. Cl.: G01R 31/36, G01R 31/396, G01R 31/382, G01R 31/392

(54) **APPARATUS AND METHOD FOR MANAGING BATTERY**

(30) Priority: 09.08.2023 KR 20230104429
(71) Applicant: LG Energy Solution, Ltd., Seoul 07335 (KR)
(72) Inventor: SONG, Hee-Seok, Daejeon 34122 (KR); KIM, Yong-Jun, Daejeon 34122 (KR); BAE, Yoon-Jung, Daejeon 34122 (KR)
(74) Representative: Goddar, Heinz J.
(86) International application number: PCT/KR2024/010861
(87) International publication number: WO 2025/033785

(57) **Abstract**

A battery management apparatus according to an embodiment of the present disclosure includes a profile obtaining unit configured to obtain a differential profile representing a corresponding relationship between a differential capacity and a voltage of a battery; and a control unit configured to determine a plurality of peaks in the differential profile, calculate a capacity of each of a plurality of voltage sections distinguished based on the plurality of peaks, calculate a capacity change rate of each of the plurality of voltage sections based on the calculated plurality of capacities and a preset reference capacity, and diagnose a state of the battery according to the calculated plurality of capacity change rates.

## Description

### TECHNICAL FIELD

The present application claims priority to Korean Patent Application No. 10-2023-0104429 filed on August 9, 2023 in the Republic of Korea, the disclosures of which are incorporated herein by reference.

The present disclosure relates to a battery management apparatus and method, and more particularly, to a battery management apparatus and method for diagnosing a state of a battery and controlling a use condition of the battery according to the diagnosis result.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing a battery management apparatus and method capable of tracking and diagnosing a state of a battery to increase the lifespan of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a profile obtaining unit configured to obtain a differential profile representing a corresponding relationship between a differential capacity and a voltage of a battery; and a control unit configured to determine a plurality of peaks in the differential profile, calculate a capacity of each of a plurality of voltage sections distinguished based on the plurality of peaks, calculate a capacity change rate of each of the plurality of voltage sections based on the calculated plurality of capacities and a preset reference capacity, and diagnose a state of the battery according to the calculated plurality of capacity change rates.

The control unit may be configured to compare a capacity change rate of a target voltage section among the plurality of voltage sections with capacity change rates of the remaining voltage sections, and diagnose the state of the battery based on the comparison result.

The control unit may be configured to diagnose the state of the battery as a deterioration accelerated state when the capacity change rate of the target voltage section is smallest among the plurality of capacity change rates.

The control unit may be configured to adjust a use condition preset for the battery based on the state of the battery.

The control unit may be configured to reduce at least one of a charge end voltage and an upper limit temperature based on at least one of the plurality of capacity change rates when the state of the battery is diagnosed as a deterioration accelerated state.

The reference capacity may be set for each of the plurality of voltage sections.

The control unit may be configured to compare the capacities of the plurality of voltage sections with a corresponding reference capacity to calculate the capacity change rate of each of the plurality of voltage sections.

The control unit may be configured to integrate each of the plurality of voltage sections in the differential profile with respect to the voltage to calculate the plurality of capacities.

The control unit may be configured to determine a minimum point of the differential profile as the peak.

A battery pack according to another aspect of the present disclosure may comprise the battery management apparatus according to an aspect of the present disclosure.

A vehicle according to another aspect of the present disclosure may comprise the battery management apparatus according to an aspect of the present disclosure.

A battery management method according to still another aspect of the present disclosure may comprise: a profile obtaining step of obtaining a differential profile representing a corresponding relationship between a differential capacity and a voltage of a battery; a peak determining step of determining a plurality of peaks in the differential profile; a capacity calculating step of calculating a capacity of each of a plurality of voltage sections distinguished based on the plurality of peaks; a capacity change rate calculating step of calculating a capacity change rate of each of the plurality of voltage sections based on the calculated plurality of capacities and a preset reference capacity; and a state diagnosing step of diagnosing a state of the battery according to the calculated plurality of capacity change rates.

### Advantageous Effects

According to one aspect of the present disclosure, the battery management apparatus may distinguish the voltage sections based on a plurality of peaks, and diagnose the state of the battery according to the capacity change rate for the distinguished voltage sections. That is, the battery management apparatus has an advantage in that it may track and diagnose the state of the battery by considering the change in the capacity change rate for each voltage section of the battery.

In addition, a plurality of voltage sections are distinguished based on a peak that reflects the state of the battery at the corresponding time point. Therefore, the battery management apparatus may accurately diagnose the state of the battery for each time point based on the capacity change rate of each voltage section.

In addition, according to one aspect of the present disclosure, since the use condition of the battery is appropriately adjusted according to the state of the battery, the life of the battery may be increased.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIGS. 2 to 5 are schematic drawings illustrating a plurality of differential profiles according to an embodiment of the present disclosure.
FIG. 6 is a drawing illustrating a capacity of a plurality of differential profiles for each voltage section according to an embodiment of the present disclosure.
FIG. 7 is a drawing illustrating a capacity change rate of a plurality of differential profiles for each voltage section according to an embodiment of the present disclosure.
FIG. 8 is a diagram schematically showing an exemplary configuration of a battery pack according to another embodiment of the present disclosure.
FIG. 9 is a diagram schematically showing a vehicle according to another embodiment of the present disclosure.
FIG. 10 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

A battery means a physically separable independent cell including a negative electrode terminal and a positive electrode terminal. For example, a lithium-ion battery or a lithium polymer battery may be considered a battery. In addition, a battery may mean a battery module in which a plurality of cells are connected in series and/or in parallel. Hereinafter, for convenience of explanation, a battery is described as meaning a single independent cell.

Hereinafter, preferred embodiments of the present disclosure will be described in detail with reference to the accompanying drawings.

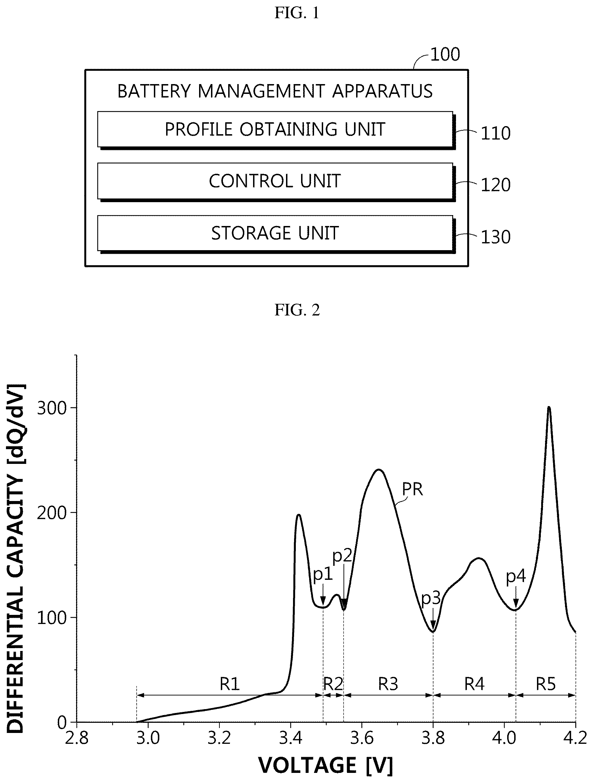

FIG. 1 is a diagram schematically showing a battery management apparatus 100 according to an embodiment of the present disclosure.

Referring to FIG. 1, the battery management apparatus 100 may include a profile obtaining unit 110 and a control unit 120.

The profile obtaining unit 110 may be configured to obtain a differential profile representing a corresponding relationship between the differential capacity and voltage of the battery.

Here, the differential capacity represents the instantaneous change rate of the capacity with respect to the voltage. That is, the differential capacity may be expressed as 'dQ/dV' as a value obtained by differentiating the capacity with respect to the voltage.

Specifically, the battery profile is a profile representing the corresponding relationship between voltage (V) and capacity (Q) when the SOC of the battery is charged from 0% to 100%. Also, when the battery profile is differentiated with respect to voltage, a differential profile representing the corresponding relationship between differential capacity (dQ/dV) and voltage (V) may be generated. Conversely, the battery profile may also represent the corresponding relationship between voltage (V) and capacity (Q) when the SOC of the battery is discharged from 100% to 0%.

For example, there is no special limitation on the C-rate in charge or discharge for generating a battery profile. However, preferably, the battery should be charged or discharged at a low rate to obtain a more accurate battery profile and differential profile. For example, a battery profile may be generated in the process of charging or discharging a battery at 0.05 C.

For example, the profile obtaining unit 110 may directly receive the differential profile of the battery from the outside. That is, the profile obtaining unit 110 may obtain the differential profile by being connected to the outside by wire and/or wirelessly and receiving the differential profile.

As another example, the profile obtaining unit 110 may receive battery information about the voltage and capacity of the battery. Also, the profile obtaining unit 110 may generate a battery profile based on the received battery information, and generate a differential profile based on the generated battery profile. That is, the profile obtaining unit 110 may obtain a differential profile by directly generating a differential profile based on the battery information.

FIGS. 2 to 5 are schematic drawings illustrating a plurality of differential profiles PR, PA, PB, PC according to an embodiment of the present disclosure.

The embodiment of FIG. 2 is a drawing illustrating a reference differential profile PR of a battery in a BOL (Beginning of life) state. For example, the reference differential profile PR is a differential profile of the battery in the first charge and discharge cycle.

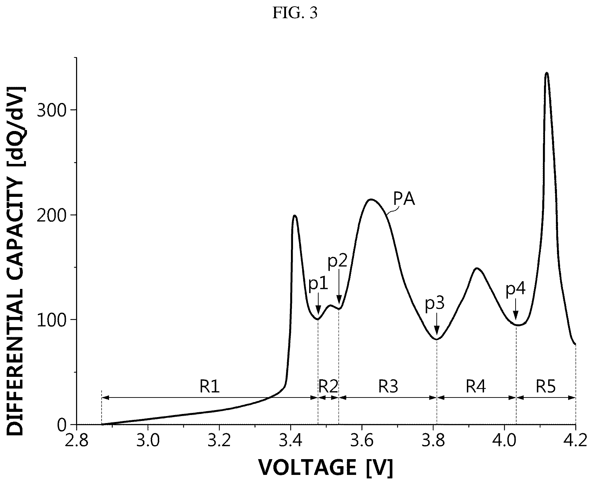

The embodiment of FIG. 3 is a drawing illustrating a first differential profile PA of a battery. For example, the first differential profile PA is a differential profile of the battery in the 100th charge and discharge cycle.

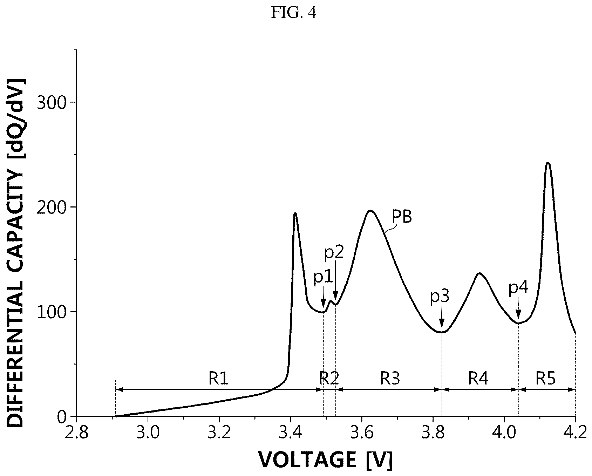

The embodiment of FIG. 4 is a drawing illustrating a second differential profile PB of a battery. For example, the second differential profile PB is a differential profile of the battery in the 200th charge and discharge cycle.

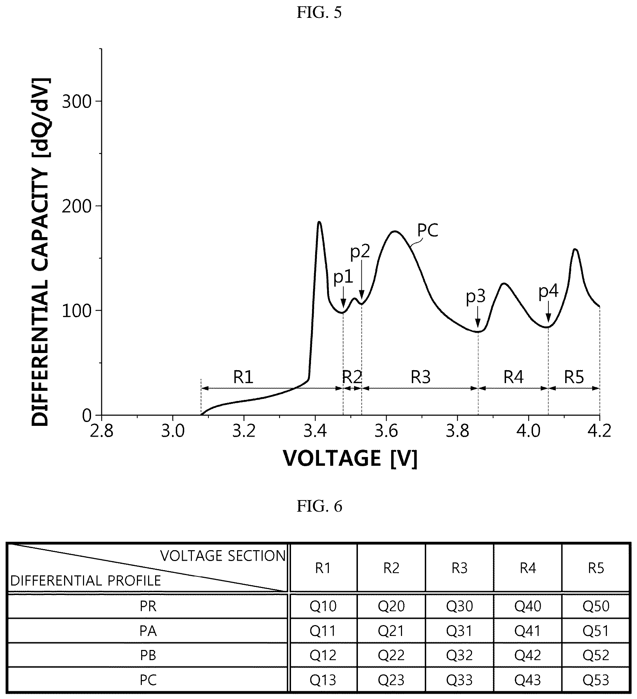

The embodiment of FIG. 5 is a drawing illustrating a third differential profile PC of a battery. For example, the third differential profile PC is a differential profile of the battery at the 300th charge and discharge cycle.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile to the control unit 120.

The control unit 120 may be configured to determine a plurality of peaks in the differential profile.

Specifically, the control unit 120 may determine a point in the differential profile where the slope (instantaneous change rate) is 0 and the shape is convex downward as a peak. That is, the slope on the low voltage side centered on the peak is negative, and the slope on the high voltage side is positive. In other words, the control unit 120 may be configured to determine the minimum point of the differential profile as the peak.

For example, in the embodiments of FIGS. 2 to 5, the reference differential profile PR, the first differential profile PA, the second differential profile PB, and the third differential profile PC may include a first peak p1, a second peak p2, a third peak p3, and a fourth peak p4. Here, the peaks that appear depending on the composition of the battery may be different from the embodiments of FIGS. 2 to 5. For example, in another battery, the first peak p1 and the second peak p2 may not be distinguished and may appear as a single peak.

The control unit 120 may be configured to calculate the capacity of each of the plurality of voltage sections that are distinguished based on the plurality of peaks.

Specifically, the control unit 120 may distinguish the available voltage section of the battery into a plurality of voltage sections based on the plurality of peaks. For example, the control unit 120 may distinguish a plurality of voltage sections based on voltage values corresponding to the plurality of peaks.

For example, in the embodiments of FIGS. 2 to 5, each of the differential profiles PR, PA, PB, and PC includes first to fourth peaks p1, p2, p3, p4. Accordingly, the control unit 120 may distinguish each of the differential profiles PR, PA, PB, PC into five voltage sections. That is, the control unit 120 may distinguish each of the differential profiles PR, PA, PB, PC into a first voltage section R1, a second voltage section R2, a third voltage section R3, a fourth voltage section R4, and a fifth voltage section R5.

Also, the control unit 120 may calculate the capacity of each of the distinguished plurality of voltage sections.

Specifically, the differential profile is a profile that represents a corresponding relationship between voltage and differential capacity. That is, the area of a voltage section in the differential profile represents the capacity of the battery in the corresponding voltage section. Accordingly, the control unit 120 may be configured to calculate a plurality of capacities by integrating each of the plurality of voltage sections in the differential profile with respect to voltage.

FIG. 6 is a drawing illustrating a capacity of a plurality of differential profiles PR, PA, PB, PC for each voltage section according to an embodiment of the present disclosure.

The capacity corresponding to the first voltage section R1 of the reference differential profile PR is Q10, the capacity corresponding to the second voltage section R2 is Q20, the capacity corresponding to the third voltage section R3 is Q30, the capacity corresponding to the fourth voltage section R4 is Q40, and the capacity corresponding to the fifth voltage section R5 is Q50.

The capacity corresponding to the first voltage section R1 of the first differential profile PA is Q11, the capacity corresponding to the second voltage section R2 is Q21, the capacity corresponding to the third voltage section R3 is Q31, the capacity corresponding to the fourth voltage section R4 is Q41, and the capacity corresponding to the fifth voltage section R5 is Q51.

The capacity corresponding to the first voltage section R1 of the second differential profile PB is Q12, the capacity corresponding to the second voltage section R2 is Q22, the capacity corresponding to the third voltage section R3 is Q32, the capacity corresponding to the fourth voltage section R4 is Q42, and the capacity corresponding to the fifth voltage section R5 is Q52.

The capacity corresponding to the first voltage section R1 of the third differential profile PC is Q13, the capacity corresponding to the second voltage section R2 is Q23, the capacity corresponding to the third voltage section R3 is Q33, the capacity corresponding to the fourth voltage section R4 is Q43, and the capacity corresponding to the fifth voltage section R5 is Q53.

The control unit 120 may be configured to calculate a capacity change rate of each of the plurality of voltage sections based on the calculated plurality of capacities and a preset reference capacity.

Here, the reference capacity may be set for each of a plurality of voltage sections. For example, the reference capacity may be set for each of the first voltage section R1, the second voltage section R2, the third voltage section R3, the fourth voltage section R4, and the fifth voltage section R5. More specifically, the first reference capacity (Q10) is set for the first voltage section R1, the second reference capacity (Q20) is set for the second voltage section R2, and the third reference capacity (Q30) is set for the third voltage section R3. Similarly, the fourth reference capacity (Q40) is set for the fourth voltage section R4, and the fifth reference capacity (Q50) is set for the fifth voltage section R5. Here, it is preferable that the first to fifth reference capacities (Q10, Q20, Q30, Q40, Q50) are independent capacity values.

Specifically, the reference capacity of each of the plurality of voltage sections may be set as the capacity of each voltage section of the reference differential profile PR. In order to track and diagnose the state of the battery, it is preferable that the initial capacity information for the corresponding battery is set as the reference information. In addition, since the reference differential profile PR is the differential profile of the battery of the first charge and discharge cycle, the capacity of each voltage section of the reference differential profile PR corresponds to the initial capacity information of the battery. Therefore, the capacity of each voltage section of the reference differential profile PR may be set as the reference capacity for the corresponding voltage section.

For example, in the embodiment of FIG. 6, the reference capacity of the first voltage section R1 is Q10, the reference capacity of the second voltage section R2 is Q20, the reference capacity of the third voltage section R3 is Q30, the reference capacity of the fourth voltage section R4 is Q40, and the reference capacity of the fifth voltage section R5 is Q50.

The control unit 120 may be configured to calculate a capacity change rate of each of the plurality of voltage sections by comparing the capacities of the plurality of voltage sections with a corresponding reference capacity.

Specifically, the capacity change rate may be calculated as a ratio of the capacity to the reference capacity. For example, the control unit 120 may calculate the capacity change rate by calculating the formula "capacity ÷ reference capacity × 100". Note that the capacity and the reference capacity are for the same voltage section.

Also, in the formula of "capacity ÷ reference capacity × 100", 100 is a constant for representing the capacity change rate in the range of 0% to 100%, and thus can be omitted. If this constant is omitted, the capacity change rate may have a value in the range of 0 to 1.

For example, in the embodiment of FIG. 6, the capacity change rate of the first voltage section R1 of the first differential profile PA is "Q11 ÷ Q10 × 100", the capacity change rate of the second voltage section R2 is "Q21 ÷ Q20 × 100", the capacity change rate of the third voltage section R3 is "Q31 ÷ Q30 × 100", the capacity change rate of the fourth voltage section R4 is "Q41 ÷ Q40 × 100", and the capacity change rate of the fifth voltage section R5 is "Q51 ÷ Q50 × 100". In this manner, the capacity change rates for each voltage section of the second differential profile PB and the third differential profile PC may be calculated.

The control unit 120 may be configured to diagnose the state of the battery based on the calculated plurality of capacity change rates.

Specifically, the control unit 120 may diagnose the state of the battery by comparing the capacity change rates of the plurality of voltage sections with each other. That is, the control unit 120 does not compare the capacity change rates at different time points (cycles), but compares the plurality of capacity change rates at the same time point (cycle).

For example, in the embodiment of FIG. 3, the control unit 120 may diagnose the state of the battery at a time point corresponding to the first differential profile PA by comparing the capacity change rate of the first voltage section R1, the capacity change rate of the second voltage section R2, the capacity change rate of the third voltage section R3, and the capacity change rate of the fourth voltage section R4.

The battery management apparatus 100 according to an embodiment of the present disclosure may distinguish voltage sections based on a plurality of peaks, and diagnose the state of the battery according to the capacity change rate for the distinguished voltage sections. That is, the battery management apparatus 100 has an advantage in that it may track and diagnose the state of the battery by considering the change in the capacity change rate for each voltage section of the battery.

In addition, the plurality of voltage sections are distinguished based on a peak that reflects the state of the battery at the corresponding time point. Therefore, the battery management apparatus 100 may accurately diagnose the state of the battery for each time point based on the capacity change rate of each voltage section.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store the differential profile obtained by the profile obtaining unit 110. In addition, the storage unit 130 may store the capacity and the capacity change rate for each voltage section calculated by the control unit 120. The control unit 120 may access the storage unit 130 to obtain necessary data.

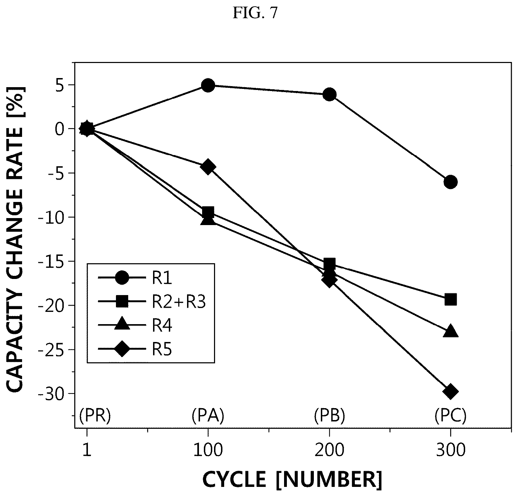

FIG. 7 is a drawing illustrating a capacity change rate of a plurality of differential profiles PR, PA, PB, PC for each voltage section according to an embodiment of the present disclosure. Specifically, the capacity change rate of the first cycle in FIG. 7 is based on the reference differential profile PR of FIGS. 2 and 6, and the capacity change rate of the 100th cycle is based on the first differential profile PA of FIGS. 3 and 6. In addition, the capacity change rate of the 200th cycle is based on the second differential profile PB of FIGS. 4 and 6, and the capacity change rate of the 300th cycle is based on the third differential profile PC of FIGS. 5 and 6.

In addition, FIG. 7 is a diagram showing the capacity change rate for the first voltage section R1, the second and third voltage sections R2 + R3, the fourth voltage section R4, and the fifth voltage section R5. Here, since the capacity change rate of the second voltage section R2 does not show a significant difference, the capacity change rate of the second voltage section R2 and the capacity change rate of the third voltage section R3 are integrated (R2 + R3) and shown.

The control unit 120 may be configured to compare the capacity change rate of a target voltage section among the plurality of voltage sections with the capacity change rates of the remaining voltage sections.

Specifically, the target voltage section may be set to a voltage section on the highest voltage side among the plurality of voltage sections. For example, in the embodiment of FIG. 6, the target voltage section may be set to the fifth voltage section R5.

Here, the voltage section on the highest voltage side is a voltage section that represents the deterioration state of the high potential region of the positive electrode. In this voltage section, the reaction of the positive electrode is actively shown, but conversely, the reaction of the negative electrode hardly occurs. For example, in this voltage section, as the capacity (or SOC (State of Charge)) of the positive electrode increases, the positive electrode potential also significantly increases. Conversely, even if the capacity of the negative electrode increases, the negative electrode potential may not change or may have a minimal change. This voltage section is also called a negative electrode flat section in which the potential change of the negative electrode hardly occurs. Therefore, the target voltage section may be selected as a voltage section on the highest voltage side in which only the reaction of the positive electrode is actively shown.

The control unit 120 may be configured to diagnose the state of the battery based on the comparison result.

Specifically, the control unit 120 may diagnose the state of the battery by comparing the magnitude of a plurality of capacity change rates. Preferably, the control unit 120 may compare the magnitude of the capacity change rate of the target voltage section with the capacity change rates of the remaining voltage sections.

For example, if the capacity change rate of the target voltage section is smallest among the plurality of capacity change rates, the control unit 120 may be configured to diagnose the state of the battery as a deterioration accelerated state.

In the embodiment of FIG. 7, it is assumed that the fifth voltage section R5 is the target voltage section. In the 200th cycle, the capacity change rate of the fifth voltage section R5 may be smallest among the plurality of capacity change rates. The control unit 120 may diagnose the state of the battery in the 200th cycle as a deterioration accelerated state. Similarly, since the capacity change rate of the fifth voltage section R5 in the 300th cycle is also smallest among the plurality of capacity change rates, the control unit 120 may diagnose the state of the battery in the 300th cycle as a deterioration accelerated state.

Specifically, if the capacity change rate of the target voltage section is smallest among the plurality of capacity change rates, the control unit 120 may be configured to diagnose the state of the battery as a positive electrode deterioration accelerated state.

In the embodiment of FIG. 7, the control unit 120 may diagnose the state of the battery of the 200th cycle and the 300th cycle as a positive electrode deterioration accelerated state.

As explained above, the target voltage section may be a voltage section that best represents the deterioration state of the high potential side of the positive electrode. The fact that the capacity change rate of this target voltage section is smaller than the capacity change rates of other voltage sections indicates that the capacity of the target voltage section has decreased most compared to the initial capacity. In other words, when the capacity degradation of the high potential region of the positive electrode is most severe compared to the remaining regions, the capacity change rate of the target voltage section may have the smallest value. Therefore, the control unit 120 may diagnose whether the deterioration of the positive electrode is accelerated based on the result of comparing the capacity change rate of the target voltage section with the capacity change rates of the remaining voltage sections.

The battery management apparatus 100 according to an embodiment of the present disclosure may diagnose the deterioration accelerated state of a battery, specifically, the deterioration accelerated state of a positive electrode of the battery. That is, the battery management apparatus 100 may specifically diagnose not only whether the battery is in the deterioration accelerated state, but also the target electrode in the deterioration accelerated state. Therefore, the battery management apparatus 100 has an advantage in that it may diagnose the specific deterioration state of a battery.

Below, an embodiment in which control unit 120 adjusts the use condition of a battery according to the diagnosed state of the battery is described.

The control unit 120 may be configured to adjust a use condition preset for the battery based on the state of the battery.

For example, the use condition set for the battery may include the charge end voltage, the discharge end voltage, the upper limit temperature, and the upper limit of the charge and discharge C-rate. If the use condition is adjusted according to the state of the battery, the degradation of the battery may be delayed. This is because the battery may be deviated from a vulnerable deterioration environment (or deterioration cause) as the use condition changes.

For example, if the cause of battery deterioration is capacity loss on the positive electrode high potential side, the control unit 120 may prevent a reaction from occurring on the positive electrode high potential side by reducing the charge end voltage. In addition, the control unit 120 may prevent the reaction of the battery from occurring too actively by reducing the upper limit temperature. In other words, the control unit 120 may prevent further deterioration of the positive electrode by reducing the charge end voltage and/or the upper limit temperature.

As another example, if the cause of battery deterioration is rapid charging, the control unit 120 may prevent rapid charging from occurring by reducing the upper limit of the charge and discharge C-rate.

As another example, if the cause of battery deterioration is capacity loss on the negative electrode high potential side, the control unit 120 may prevent a reaction from occurring on the negative electrode high potential side by increasing the discharge end voltage.

That is, the control unit 120 may appropriately adjust the use condition depending on the cause of deterioration.

Specifically, the control unit 120 may diagnose whether the state of the battery is a deterioration accelerated state. More specifically, the control unit 120 may diagnose whether the state of the battery is a positive electrode deterioration accelerated state. Accordingly, the control unit 120 may be configured to reduce at least one of the charge end voltage and the upper limit temperature if the state of the battery is diagnosed as a deterioration accelerated state.

The battery management apparatus has the advantage of being able to prevent further deterioration of the battery by appropriately adjusting the use condition to correspond to the cause of battery deterioration. In other words, the lifespan of the battery may be extended by adjusting the use condition of the battery management apparatus.

The control unit 120 may be configured to reduce at least one of the charge end voltage and the upper limit temperature based on at least one of the plurality of capacity change rates when the state of the battery is diagnosed as a deterioration accelerated state.

Specifically, the control unit 120 may determine the target voltage and/or the target temperature based on at least one of the plurality of capacity change rates.

In one embodiment, the control unit 120 may determine the target voltage and/or the target temperature based on the capacity change rate of the target voltage section among the plurality of capacity change rates. Here, mapping information of the target voltage and/or the target temperature for the capacity change rate of the target voltage section may be stored in advance. The control unit 120 may determine the target voltage and/or the target temperature corresponding to the capacity change rate of the target voltage section using the mapping information.

In another embodiment, mapping information of the target voltage and/or the target temperature for the capacity change rate and the charge and discharge cycle of the target voltage section may be stored in advance. The control unit 120 may use this mapping information to determine the target voltage and/or the target temperature corresponding to the capacity change rate and the charge and discharge cycle of the target voltage section.

In another embodiment, the control unit 120 may calculate the difference between the capacity change rate of the target voltage section and each of the remaining capacity change rates, and determine the target voltage and/or the target temperature based on the sum of the calculated plurality of capacity change rate differences.

For example, assuming that the charge end voltage is 4.2 [V] and the target voltage calculated based on the plurality of capacity change rates is 10 [mV], the control unit 120 may reduce the charge end voltage to 4.19 [V]. As another example, assuming that the upper limit temperature is 50 [°C] and the target temperature calculated based on the plurality of capacity change rates is 5 [°C], the control unit 120 may reduce the upper limit temperature to 45 [°C].

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the profile obtaining unit 110, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

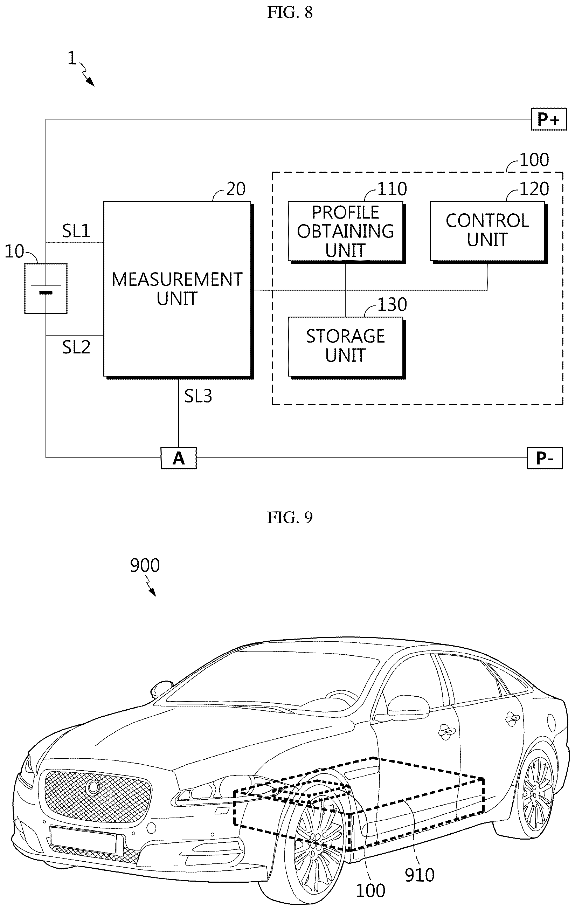

FIG. 8 is a diagram showing an exemplary configuration of a battery pack according to another embodiment of the present disclosure.

The positive electrode terminal of the battery 10 may be connected to the positive electrode terminal P+ of the battery pack 1, and the negative electrode terminal of the battery 1 may be connected to the negative electrode terminal P- of the battery pack 1.

A measurement unit 20 may be connected to a first sensing line SL1, a second sensing line SL2, and a third sensing line SL3. Specifically, the measurement unit 20 may be connected to a positive electrode terminal of the battery 10 through the first sensing line SL1, and may be connected to a negative electrode terminal of the battery 10 through the second sensing line SL2. The measurement unit 20 may measure the voltage of the battery 10 based on the voltage measured at each of the first sensing line SL1 and the second sensing line SL2.

In addition, the measurement unit 20 may be connected to an ampere meter A through the third sensing line SL3. For example, the ampere meter A may be an ammeter or a shunt resistor capable of measuring the charging current and the discharging current of the battery 10. The measurement unit 20 may calculate the charge amount by measuring the charging current of the battery 10 through the third sensing line SL3. Also, the measurement unit 20 may calculate the discharge amount by measuring the discharge current of the battery 10 through the third sensing line SL3.

One end of the load may be connected to the positive electrode terminal P+ of the battery pack 1, and the other end may be connected to the negative electrode terminal P- of the battery pack 1. Accordingly, the positive electrode terminal of the battery 10, the positive electrode terminal P+ of the battery pack 1, the load, the negative electrode terminal P- of the battery pack 1, and the negative electrode terminal of the battery 10 may be electrically connected.

For example, the load may be a charge and discharge device, or a motor of an electric vehicle powered by the battery 10.

FIG. 9 is a diagram schematically showing a vehicle 900 according to another embodiment of the present disclosure.

Referring to FIG. 9, the battery pack according to an embodiment of the present disclosure may be included in a vehicle 900 such as an electric vehicle (EV) or a hybrid vehicle (HV). Additionally, the battery pack 910 may drive the vehicle 900 by supplying power to the motor through an inverter provided in the vehicle 900. Here, the battery pack 910 may include the battery management apparatus 100.

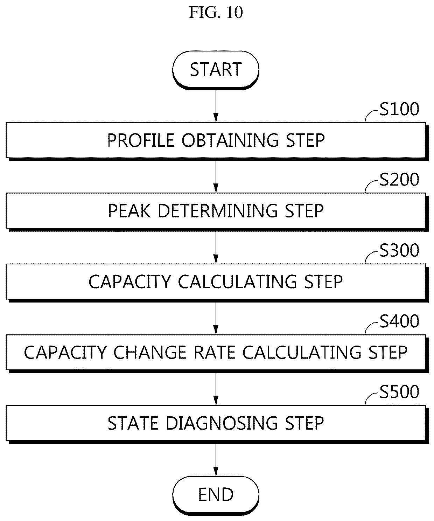

FIG. 10 is a diagram schematically showing a battery management method according to still another embodiment of the present disclosure.

Preferably, each step of the battery management method may be performed by the battery management apparatus 100. Hereinafter, for convenience of explanation, contents overlapping with the previously described contents will be omitted or briefly described.

The profile obtaining step (S100) is a step of obtaining a differential profile representing a corresponding relationship between differential capacity and voltage of a battery, and may be performed by the profile obtaining unit 110.

For example, in the embodiments of FIGS. 2 to 5, the profile obtaining unit 110 may obtain a reference differential profile PR, a first differential profile PA, a second differential profile PB, and a third differential profile PC.

The peak determining step (S200) is a step of determining a plurality of peaks in the differential profile, and may be performed by the control unit 120.

For example, the control unit 120 may be configured to determine the minimum point of the differential profile as a peak.

For example, in the embodiments of FIGS. 2 to 5, the reference differential profile PR, the first differential profile PA, the second differential profile PB, and the third differential profile PC may include a first peak p1, a second peak p2, a third peak p3, and a fourth peak p4.

The capacity calculating step (S300) is a step of calculating the capacity of each voltage section that is distinguished based on the plurality of peaks, and may be performed by the control unit 120.

Specifically, the control unit 120 may be configured to calculate a plurality of capacities by integrating each of the plurality of voltage sections in the differential profile with respect to voltage.

In the embodiment of FIG. 6, the control unit 120 may calculate the capacities of the first to fifth voltage sections R1, R2, R3, R4, R5 with respect to the reference differential profile PR, the first differential profile PA, the second differential profile PB, and the third differential profile PC.

The capacity change rate calculating step (S400) is a step of calculating a capacity change rate of each of the plurality of voltage sections based on the calculated plurality of capacities and a preset reference capacity, and may be performed by the control unit 120.

Specifically, the control unit 120 may be configured to calculate a capacity change rate of each of the plurality of voltage sections by comparing the capacities of the plurality of voltage sections with a corresponding reference capacity.

For example, in the embodiment of FIG. 6, the reference capacity of the first voltage section R1 is Q10, the reference capacity of the second voltage section R2 is Q20, the reference capacity of the third voltage section R3 is Q30, the reference capacity of the fourth voltage section R4 is Q40, and the reference capacity of the fifth voltage section R5 is Q50. The control unit 120 may calculate a capacity change rate of each of the plurality of voltage sections by calculating a ratio of the capacity to the reference capacity for each voltage section.

The state diagnosing step (S500) is a step of diagnosing the state of the battery according to the calculated plurality of capacity change rates, and may be performed by the control unit 120.

Specifically, the control unit 120 may diagnose the state of the battery by comparing the capacity change rate of each of the plurality of voltage sections.

For example, if the capacity change rate of the target voltage section is smallest among the plurality of capacity change rates, the control unit 120 may diagnose the state of the battery as a deterioration accelerated state. Also, the control unit 120 may prevent the battery from rapidly deteriorating by adjusting the use condition of the battery.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery
20: measurement unit
100: battery management apparatus
110: profile obtaining unit
120: control unit
130: storage unit
900: vehicle
910: battery pack

## Claims

1. A battery management apparatus comprising:
a profile obtaining unit configured to obtain a differential profile representing a corresponding relationship between a differential capacity and a voltage of a battery; and
a control unit configured to determine a plurality of peaks in the differential profile, calculate a capacity of each of a plurality of voltage sections distinguished based on the plurality of peaks, calculate a capacity change rate of each of the plurality of voltage sections based on the calculated plurality of capacities and a preset reference capacity, and diagnose a state of the battery according to the calculated plurality of capacity change rates.

2. The battery management apparatus according to claim 1,
wherein the control unit is configured to compare a capacity change rate of a target voltage section among the plurality of voltage sections with capacity change rates of the remaining voltage sections, and diagnose the state of the battery based on the comparison result.

3. The battery management apparatus according to claim 2,
wherein the control unit is configured to diagnose the state of the battery as a deterioration accelerated state when the capacity change rate of the target voltage section is smallest among the plurality of capacity change rates.

4. The battery management apparatus according to claim 1,
wherein the control unit is configured to adjust a use condition preset for the battery based on the state of the battery.

5. The battery management apparatus according to claim 4,
wherein the control unit is configured to reduce at least one of a charge end voltage and an upper limit temperature based on at least one of the plurality of capacity change rates when the state of the battery is diagnosed as a deterioration accelerated state.

6. The battery management apparatus according to claim 1,
wherein the reference capacity is set for each of the plurality of voltage sections, and
wherein the control unit is configured to compare the capacities of the plurality of voltage sections with a corresponding reference capacity to calculate the capacity change rate of each of the plurality of voltage sections.

7. The battery management apparatus according to claim 1,
wherein the control unit is configured to integrate each of the plurality of voltage sections in the differential profile with respect to the voltage to calculate the plurality of capacities.

8. The battery management apparatus according to claim 1,
wherein the control unit is configured to determine a minimum point of the differential profile as the peak.

9. A battery pack comprising the battery management apparatus according to any one of claims 1 to 8.

10. A vehicle comprising the battery management apparatus according to any one of claims 1 to 8.

11. A battery management method comprising:
a profile obtaining step of obtaining a differential profile representing a corresponding relationship between a differential capacity and a voltage of a battery;
a peak determining step of determining a plurality of peaks in the differential profile;
a capacity calculating step of calculating a capacity of each of a plurality of voltage sections distinguished based on the plurality of peaks;
a capacity change rate calculating step of calculating a capacity change rate of each of the plurality of voltage sections based on the calculated plurality of capacities and a preset reference capacity; and
a state diagnosing step of diagnosing a state of the battery according to the calculated plurality of capacity change rates.
